# EUROPÄISCHE PATENTANMELDUNG

(11) **EP 1 265 288 A2**
(43) Veröffentlichungstag der Anmeldung: **11.12.2002**
(21) Anmeldenummer: 02010959.1
(22) Anmeldetag: 16.05.2002
(51) Int. Cl.: H01L 27/105, H01L 21/8239, H01L 21/60

(54) **Halbleiterstruktur mit vergrabenen Leiterbahnen sowie Verfahren zur elektrischen Kontaktierung der vergrabenen Leiterbahnen**

(30) Priorität: 06.06.2001 DE 10127350
(71) Anmelder: Infineon Technologies AG, 81669 München (DE)
(72) Erfinder: Kutter, Christoph, 81541 München (DE); Ludwig, Christoph, 01465 Langebrück (DE); Morhard, Klaus-Dieter, 01099 Dresden (DE)
(74) Vertreter: Viering, Jentschura & Partner

(57) **Zusammenfassung**

Eine Halbleiterstruktur 300 weist auf mehrere erste Leiterbahnen 303, mehrere zweite Leiterbahnen 304, welche zu den ersten Leiterbahnen 303 isoliert sind und zusammen mit diesen ein Gitter bilden, und mehrere dritte Leiterbahnen 307 parallel über den ersten Leiterbahnen 303, welche teilweise die zweiten Leiterbahnen 304 überdecken und zu diesen isoliert sind, wobei zwischen jeweils zwei benachbarten zweiten Leiterbahnen 304 ein elektrischer Kontakt 305 zwischen jeder ersten Leiterbahn 303 und der jeweiligen darüber liegenden dritten Leiterbahn 307 vorgesehen ist.

## Beschreibung

Die Erfindung betrifft eine Halbleiterstruktur mit vergrabenen Leiterbahnen sowie ein Verfahren zur elektrischen Kontaktierung der vergrabenen Leiterbahnen.

Gemäß dem Stand der Technik werden Speicherzellenanordnungen, beispielsweise Flash-Speicher, als große matrixartige Speicherfelder aus Transistoren realisiert. Sowohl zum Speichern als auch zum Auslesen der Speicherzellen ist eine bestimmte Anordnung von Leiterbahnen notwendig. Dabei wird zur Platzoptimierung ein Teil der Leiterbahnen als Bitleitungen (buried bitlines) in ein Halbleitersubstrat eindiffundiert. Jedoch bringen eindiffundierte Bitleitungen das Problem mit sich, dass die elektrischen Widerstände der eindiffundierten Bitleitungen höher sind als die elektrischen Widerstände von Leiterbahnen in Metallisierungsebenen.

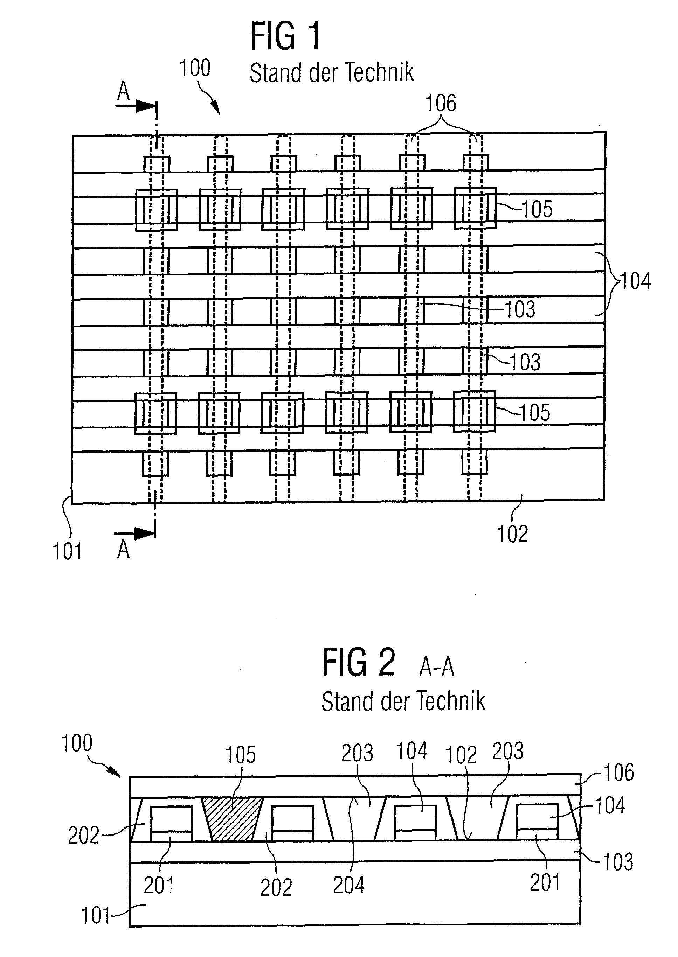

Die Höhe der Widerstandswerte der eindiffundierten Bitleitungen begrenzt auf Grund der sich ergebenden RC-Zeitkonstante folglich die Signallaufzeit. Unter dem Begriff Signallaufzeit ist die benötigte Zeit zu verstehen, mit der in Speicherzellen eingeschrieben werden kann oder diese ausgelesen werden können. Gemäß dem Stand der Technik wird zur Reduzierung der Signallaufzeit parallel zu den eindiffundierten Bitleitungen jeweils eine metallische Leiterbahn eingesetzt. Diese metallischen Leiterbahnen sind in regelmäßigen Abständen mittels Kontakten, sogenannten Stitch-Kontakten, mit den eindiffundierten Bitleitungen elektrisch verbunden. Dadurch kann der Widerstandseffekt der eindiffundierten Bitleitungen und somit die Signallaufzeit reduziert werden. Zur Veranschaulichung ist in Fig.1 und Fig.2 eine Halbleiterstruktur dargestellt, welche eine solche Speicherzellenanordnung repräsentiert.

**Fig.1** zeigt eine Draufsicht auf eine Halbleiterstruktur 100 gemäß dem Stand der Technik.

In einem Halbleitersubstrat 101 ist an einer Substratoberfläche 102 eine Gruppe erster Leiterbahnen 103 integriert. Die ersten Leiterbahnen 103 sind parallel nebeneinander angeordnet und schließen mit der Substratoberfläche 102 im Wesentlichen bündig ab. Üblicherweise werden die ersten Leiterbahnen 103 mittels Eindiffusion von elektrisch leitfähigen Ionen in das Halbleitersubstrat 101 hergestellt. Die ersten Leiterbahnen 103 können beispielsweise als vergrabene Bitleitungen (buried bitlines) vorgesehen sein.

Des Weiteren befindet sich auf der Substratoberfläche 102 des Halbleitersubstrats 101 eine Gruppe zweiter Leiterbahnen 104, welche auf der Substratoberfläche 102 parallel nebeneinander und zu den ersten Leiterbahnen 103 elektrisch isoliert angeordnet sind. Die zweiten Leiterbahnen 104 bilden zusammen mit den ersten Leiterbahnen 103 ein regelmäßiges Gitter. Üblicherweise werden die zweiten Leiterbahnen 104 mittels gängiger Verfahren zur Herstellung von Metallisierungsebenen erzeugt.

Jeweils zwei benachbarte erste Leiterbahnen 103 sowie eine darüber liegende zweite Leiterbahn 104 bilden einen Transistor. Die beiden ersten Leiterbahnen 103 übernehmen im Transistorgebiet die Funktion der beiden Transistorelektroden "Source" und "Drain", weshalb die ersten Leiterbahnen 103 als Bitleitungen bezeichnet werden. Die zweite Leiterbahn 104 übernimmt im Transistorgebiet die Funktion der Transistorelektrode "Gate", weshalb die zweiten Leiterbahnen 104 als Wortleitungen bezeichnet werden.

Auf der Substratoberfläche 102 befindet sich in jedem Transistorgebiet zwischen den ersten Leiterbahnen 103 und unterhalb einer jeden zweiten Leiterbahn 104 eine Oxid-Nitrid-Oxid-Schichtenfolge (nicht dargestellt) aus Siliziumdioxid (SiO₂) und Siliziumnitrid (Si₃N₄), wobei in der Siliziumnitrid-Schicht bis zu zwei Bit gespeichert werden können.

Zur Reduzierung des elektrischen Widerstands werden die ersten Leiterbahnen 103 mittels selbstjustierender Kontakte 105 an metallische Bitleitungen 106 angeschlossen. Diese metallischen Bitleitungen 106 verlaufen parallel über den ersten Leiterbahnen 103, überbrücken die zweiten Leiterbahnen 104 und sind zu den zweiten Leiterbahnen 104 elektrisch isoliert. Dabei ist eine Kontaktierung zwischen den ersten Leiterbahnen 103 und den metallischen Bitleitungen 106 in Richtung der metallischen Bitleitungen 106 mittels der selbstjustierenden Kontakte 105 nach jeweils vier zweiten Leiterbahnen 104 vorgesehen.

**Fig.2** zeigt einen Ausschnitt eines Querschnitts durch die Halbleiterstruktur 100 aus Fig.1 entlang der Schnittlinie A-A.

Über der Substratoberfläche 102 und somit oberhalb der in dem Halbleitersubstrat 101 integrierten ersten Leiterbahnen 103 befindet sich eine erste Isolationsschicht 201. Die erste Isolationsschicht 201 ist zur elektrischen Isolierung zwischen den zweiten Leiterbahnen 104 und den ersten Leiterbahnen 103 vorgesehen. Des Weiteren sind die zweiten Leiterbahnen 104 von einer zweiten Isolationsschicht 202 eingekapselt und eine dritte Isolationsschicht 203 füllt leere Bereiche zwischen den zweiten Leiterbahnen 104 auf, um eine elektrische Isolierung der zweiten Leiterbahnen 104 zu den selbstjustierenden Kontakten 105 und zu den metallischen Bitleitungen 106 zu gewährleisten.

Zum Erzeugen der selbstjustierenden Kontakte 105 wird üblicherweise folgende Prozessfolge angewendet: Nach dem Erzeugen der ersten Isolationsschicht 201 und der zweiten Leiterbahnen 104 werden die zweiten Leiterbahnen 104 von einer zweiten Isolationsschicht 202 eingekapselt. Dazu wird zunächst ein Isolationsmaterial flächig über den zweiten Leiterbahnen 104 abgeschieden. Über den zweiten Leiterbahnen 104 wird nachfolgend eine Ätzmaske aufgebracht und das Isolationsmaterial an freiliegenden Stellen, welche nicht von der Ätzmaske bedeckt werden, bis zur Substratoberfläche 102 entfernt. Anschließend wird die Ätzmaske wieder entfernt.

In den freiliegenden Öffnungen zwischen den zweiten Leiterbahnen 104 wird dann die dritte Isolationsschicht 203 erzeugt. Dabei wird als Material für die dritte Isolationsschicht 203 üblicherweise ein Isolationsmaterial verwendet, welches selektiv zum Isolationsmaterial der zweiten Isolationsschicht 202 geätzt werden kann. Beispielsweise können für die zweite Isolationsschicht 202 Siliziumnitrid (Si₃N₄) und für die dritte Isolationsschicht 203 Siliziumdioxid (SiO₂) verwendet werden.

Zum endgültigen Erzeugen der selbstjustierenden Kontakte 105 wird nun an bestimmten Stellen die dritte Isolationsschicht 203 entfernt und somit werden die ersten Leiterbahnen 103 lokal wieder freigelegt. Diese bestimmten Stellen werden anschließend mit einem elektrisch leitenden Material, beispielsweise Wolfram, gefüllt, bis die zweite Isolationsschicht 202, die verbleibende dritte Isolationsschicht 203 und die mit elektrisch leitendem Material gefüllten bestimmten Stellen eine gemeinsame Oberfläche 204 parallel zur Substratoberfläche 102 aufweisen. Die mit elektrisch leitendem Material gefüllten bestimmten Stellen übernehmen nun die Funktion von selbstjustierenden Kontakten 105.

Abschließend befinden sich auf der gemeinsamen Oberfläche 204 noch die metallischen Bitleitungen 106, welche zum Einkoppeln von elektrischen Signalen in die Halbleiterstruktur 100 notwendig sind. Des Weiteren schaffen die metallischen Bitleitungen 106 eine Möglichkeit zum Kontaktieren der integrierten ersten Leiterbahnen 103 über mehrere selbstjustierende Kontakte 105.

Wie oben bereits erwähnt, wird also zur Reduzierung der Signallaufzeit gemäß dem Stand der Technik parallel zu den eindiffundierten Bitleitungen jeweils eine metallische Bitleitung eingesetzt. Die metallischen Bitleitungen sind im Abstand von vier Wortleitungen mittels der selbstjustierenden Kontakte mit den eindiffundierten Bitleitungen elektrisch verbunden. Dabei justieren sich die Kontakte selbst nur senkrecht zu den zweiten Leiterbahnen.

Mit dem beschriebenen Herstellungsverfahren für die selbstjustierenden Kontakte ist jedoch keine Justierung parallel zu den zweiten Leiterbahnen möglich. Es besteht somit die Gefahr, dass ein Kontakt parallel zu den zweiten Leiterbahnen verschoben hergestellt wird. Ein derartig verschobener Kontakt kann zu einer elektrostatischen Beeinflussung des Halbleitersubstrats führen, wodurch es zu einem elektrischen Kurzschluss zwischen benachbarten eindiffundierten Bitleitungen kommen kann. Ein solcher Kurzschluss führt unweigerlich zum Ausfall der direkt benachbarten Transistoren. Möglicherweise sind sogar alle Transistoren der beteiligten Bitleitungen von dieser Störung betroffen. Somit muss bei der Herstellung der Ätzmaske während des Herstellungsprozesses jedes einzelnen Kontakts die Ätzmaske sehr präzise und aufwändig positioniert werden.

Der Erfindung liegt somit das Problem zugrunde, eine Halbleiterstruktur sowie ein Verfahren zur elektrischen Kontaktierung anzugeben, bei der/dem die Signallaufzeiten in der Halbleiterstruktur weiter verringert werden sowie eine sicherere Kontaktierung gewährleistet wird.

Das Problem wird durch eine Halbleiterstruktur sowie ein Verfahren zur elektrischen Kontaktierung mit den Merkmalen gemäß den unabhängigen Patentansprüchen gelöst.

Eine Halbleiterstruktur weist auf mehrere im Wesentlichen parallel zueinander verlaufende erste Leiterbahnen, welche in einem Halbleitersubstrat vorgesehen sind. Des Weiteren weist die Halbleiterstruktur mehrere im Wesentlichen parallel zueinander verlaufende zweite Leiterbahnen auf, welche sich auf dem Halbleitersubstrat befinden, zu den ersten Leiterbahnen isoliert sind und zusammen mit den ersten Leiterbahnen ein Gitter bilden. Außerdem weist die Halbleiterstruktur mehrere dritte Leiterbahnen auf, welche im Wesentlichen parallel über den ersten Leiterbahnen angeordnet sind, teilweise die zweiten Leiterbahnen überdecken und zu den zweiten Leiterbahnen isoliert sind. Schließlich ist zwischen jeweils zwei benachbarten zweiten Leiterbahnen ein elektrischer Kontakt zwischen jeder ersten Leiterbahn und der jeweiligen darüber liegenden dritten Leiterbahn vorgesehen.

In einem Verfahren zur elektrischen Kontaktierung von mehreren im Wesentlichen parallel zueinander verlaufenden ersten Leiterbahnen, welche in einem Halbleitersubstrat vorgesehen sind, werden mehrere im Wesentlichen parallel zueinander verlaufende zweite Leiterbahnen derart auf dem Halbleitersubstrat aufgebracht, dass die zweiten Leiterbahnen zusammen mit den ersten Leiterbahnen ein Gitter bilden und dass die zweiten Leiterbahnen zu den ersten Leiterbahnen isoliert werden. Des Weiteren werden mehrere dritte Leiterbahnen im Wesentlichen parallel über den ersten Leiterbahnen und teilweise über den zweiten Leiterbahnen aufgebracht, wobei zwischen den dritten Leiterbahnen und den zweiten Leiterbahnen eine elektrische Isolierung erzeugt wird. Außerdem wird zwischen jeweils zwei benachbarten zweiten Leiterbahnen ein elektrischer Kontakt zur elektrischen Kontaktierung der ersten Leiterbahnen zwischen jeder ersten Leiterbahn und der jeweiligen darüber liegenden dritten Leiterbahn erzeugt.

Ein Vorteil der Erfindung kann darin gesehen werden, dass das Problem der langen Signallaufzeiten in der Halbleiterstruktur verringert wird, indem eine geeignete Kontaktierung der ersten Leiterbahnen mit der jeweils im Wesentlichen parallel darüber angeordneten dritten Leiterbahn mittels jeweils eines Kontaktes zwischen jeweils zwei benachbarten zweiten Leiterbahnen sichergestellt wird. Dabei können die für die jeweilige erste Leiterbahn vorgesehenen Kontakte mittels einer einzigen durchgängigen Ätzmaske, welche im Wesentlichen parallel zur ersten Leiterbahn ausgerichtet ist, hergestellt werden.

Ein weiterer Vorteil der Erfindung ist, dass auf Grund der Vielzahl an Kontakten die Kontakte senkrecht zu den ersten Leiterbahnen schmäler als die Kontakte des Standes der Technik hergestellt werden können und trotzdem keine Erhöhung der Signallaufzeit erfolgt. Wegen der schmäleren Kontakte ist in der erfindungsgemäßen Halbleiterstruktur selbst bei mangelnder Präzision der Ätzmasken-Position noch eine erfolgreiche Herstellung der Kontakte möglich. Außerdem kann bei geeigneter Strukturierung der Kontaktierung ein Teil des Herstellungsprozesses eingespart werden, woraus eine signifikante Reduzierung der Prozesskosten resultiert.

Die Kontaktierung der ersten Leiterbahnen zwischen jeweils zwei benachbarten zweiten Leiterbahnen hat auch noch den Vorteil, dass alle Stellen einer jeden ersten Leiterbahn gleichartig kontaktiert werden und dass an allen Stellen einer jeden ersten Leiterbahn die gleichen elektrischen Eigenschaften vorliegen. Somit weist jede erste Leiterbahn an allen Stellen die gleiche Signallaufzeit auf.

Bei der erfindungsgemäßen Halbleiterstruktur weisen bevorzugt die ersten Leiterbahnen jeweils eine erste Breite und die elektrischen Kontakte jeweils eine zweite Breite auf. Die beiden Breiten sind dabei parallel zu den ersten Leiterbahnen sowie senkrecht zur Längsrichtung der ersten Leiterbahnen ausgerichtet. Vorzugsweise ist die zweite Breite kleiner als die erste Breite.

Bei der erfindungsgemäßen Halbleiterstruktur wird jeweils von zwei benachbarten ersten Leiterbahnen und einer darüber liegenden zweiten Leiterbahn vorzugsweise ein Transistor gebildet. Die erfindungsgemäße Halbleiterstruktur stellt somit bevorzugt eine Transistoranordnung dar.

Weiterhin weist die erfindungsgemäße Halbleiterstruktur bevorzugt unter der zweiten Leiterbahn zwischen benachbarten ersten Leiterbahnen eine Oxid-Nitrid-Oxid-Schichtenfolge auf dem Halbleitersubstrat auf.

In einer bevorzugten Ausführungsform der erfindungsgemäßen Halbleiterstruktur ist der Transistor, welcher jeweils von zwei benachbarten ersten Leiterbahnen und einer darüber liegenden zweiten Leiterbahn gebildet wird, ein 2-bit-Speichertransistor. Somit kann die Transistoranordnung als Speicherzellenanordnung genutzt werden.

Vorzugsweise überbrücken die elektrischen Kontakte der erfindungsgemäßen Halbleiterstruktur die zweiten Leiterbahnen isoliert. Des Weiteren ist die erfindungsgemäße Halbleiterstruktur bevorzugt derart ausgebildet, dass sich elektrische Kontakte, welche über einer einzelnen der ersten Leiterbahnen benachbart sind, überlappen und somit selbst die dritten Leiterbahnen bilden. Somit entsteht eine fortlaufende, zusammenhängende Kontaktreihe. Auf eine eigenständige Metallisierungsebene, in der die dritten Leiterbahnen angeordnet sind, kann dabei verzichtet werden. Dies verringert nicht nur die Anzahl der benötigten Schichten auf dem Halbleitersubstrat sondern auch die Materialkosten für die erfindungsgemäße Halbleiterstruktur.

In einer bevorzugten Weiterbildung des erfindungsgemäßen Verfahrens werden die ersten Leiterbahnen jeweils mit einer ersten Breite und die elektrischen Kontakte jeweils mit einer zweiten Breite erzeugt. Dabei haben die beiden Breiten eine Ausrichtung parallel zu den ersten Leiterbahnen sowie senkrecht zur Längsrichtung der ersten Leiterbahnen. Vorzugsweise ist die zweite Breite kleiner als die erste Breite.

Die zweiten Leiterbahnen werden bevorzugt derart über den ersten Leiterbahnen erzeugt, dass jeweils zwei benachbarte erste Leiterbahnen und eine darüber liegende zweite Leiterbahn einen Transistor bilden. Aus den ersten Leiterbahnen und den zweiten Leiterbahnen wird somit bevorzugt eine Transistoranordnung erzeugt.

Vorzugsweise wird vor dem Erzeugen der zweiten Leiterbahnen zwischen benachbarten ersten Leiterbahnen eine Oxid-Nitrid-Oxid-Schichtenfolge auf dem Halbleitersubstrat erzeugt.

In einer bevorzugten Weiterbildung des erfindungsgemäßen Verfahrens wird der Transistor, welcher jeweils von zwei benachbarten ersten Leiterbahnen und einer darüber liegenden zweiten Leiterbahn gebildet wird, derart erzeugt, dass er als 2-bit-Speichertransistor verwendet werden kann.

Vorzugsweise werden die elektrischen Kontakte derart ausgebildet, dass diese die zweiten Leiterbahnen überbrücken und dass sich elektrische Kontakte, welche über einer einzelnen der ersten Leiterbahnen benachbart sind, überlappen und somit selbst die dritten Leiterbahnen bilden. Somit kann auf die aufwändige Herstellung einer eigenständigen Metallisierungsebene, in der die dritten Leiterbahnen angeordnet sind, verzichtet werden. Dies verringert einerseits die Anzahl der benötigten Prozessschritte im Herstellungsprozess und damit andererseits die Prozesskosten.

Ausführungsbeispiele der Erfindung sind in den Figuren dargestellt und werden im folgenden näher erläutert. Dabei bezeichnen gleiche Bezugszeichen gleiche Komponenten.

Es zeigen
- Figur 1: eine Draufsicht auf eine Halbleiterstruktur gemäß dem Stand der Technik;
- Figur 2: einen Ausschnitt eines Querschnitts durch die Halbleiterstruktur aus Fig.1 entlang der Schnittlinie A-A;
- Figur 3: eine Draufsicht auf eine Halbleiterstruktur gemäß einem ersten Ausführungsbeispiel der Erfindung;
- Figur 4: einen Ausschnitt eines Querschnitts durch die Halbleiterstruktur aus Fig.3 entlang der Schnittlinie B-B;
- Figur 5: eine Draufsicht auf eine Halbleiterstruktur gemäß einem zweiten Ausführungsbeispiel der Erfindung; und
- Figur 6: einen Ausschnitt eines Querschnitts durch die Halbleiterstruktur aus Fig.5 entlang der Schnittlinie C-C.

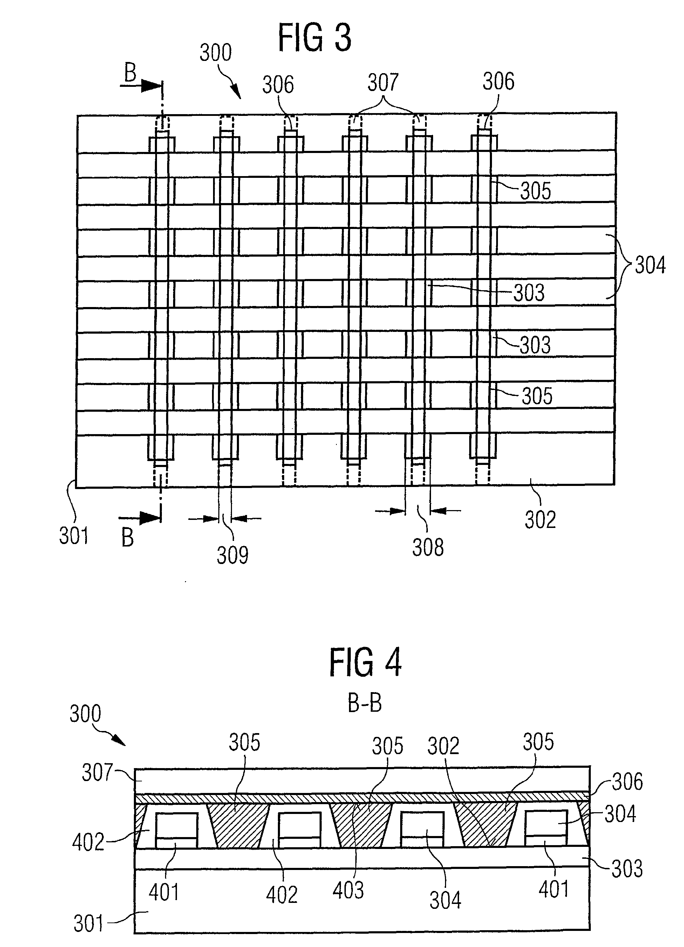

**Fig.3** zeigt eine Draufsicht auf eine Halbleiterstruktur 300 gemäß einem ersten Ausführungsbeispiel der Erfindung.

In dem ersten Ausführungsbeispiel der Erfindung ist in einem Halbleitersubstrat 301 an einer Substratoberfläche 302 eine Gruppe erster Leiterbahnen 303 integriert. Die ersten Leiterbahnen 303 sind zueinander im Wesentlichen parallel angeordnet und schließen mit der Substratoberfläche 302 im Wesentlichen bündig ab. Üblicherweise werden die ersten Leiterbahnen 303 mittels Eindiffusion von elektrisch leitfähigen Ionen in das Halbleitersubstrat 301 hergestellt.

Die ersten Leiterbahnen 303 können beispielsweise als vergrabene Bitleitungen (buried bitlines) vorgesehen sein.

Des Weiteren befindet sich auf der Substratoberfläche 302 des Halbleitersubstrats 301 eine Gruppe zweiter Leiterbahnen 304, welche auf der Substratoberfläche 302 zueinander im Wesentlichen parallel und zu den ersten Leiterbahnen 303 elektrisch isoliert angeordnet sind. Die zweiten Leiterbahnen 304 bilden zusammen mit den ersten Leiterbahnen 303 im Wesentlichen ein regelmäßiges Gitter. Üblicherweise werden die zweiten Leiterbahnen 304 mittels gängiger Verfahren zur Herstellung von Metallisierungsebenen erzeugt.

Jeweils zwei benachbarte erste Leiterbahnen 303 sowie eine darüber liegende zweite Leiterbahn 304 bilden einen Transistor. Die beiden ersten Leiterbahnen 303 übernehmen im Transistorgebiet die Funktion der beiden Transistorelektroden "Source" und "Drain", weshalb die ersten Leiterbahnen 303 als Bitleitungen bezeichnet werden. Die zweite Leiterbahn 304 übernimmt im Transistorgebiet die Funktion der Transistorelektrode "Gate", weshalb die zweiten Leiterbahnen 304 als Wortleitungen bezeichnet werden.

Auf der Substratoberfläche 302 befindet sich in jedem Transistorgebiet zwischen den ersten Leiterbahnen 303 und unterhalb einer jeden zweiten Leiterbahn 304 eine Oxid-Nitrid-Oxid-Schichtenfolge (nicht dargestellt) aus Siliziumdioxid (SiO₂) und Siliziumnitrid (Si₃N₄), wobei in der Siliziumnitrid-Schicht bis zu zwei Bit gespeichert werden können.

Die ersten Leiterbahnen 303 sind mittels selbstjustierender Kontakte 305 an metallische Kontaktleitungen 306 angeschlossen, welche ihrerseits mit metallischen Bitleitungen 307 gekoppelt sind. Die metallischen Kontaktleitungen 306 und die metallischen Bitleitungen 307 verlaufen im Wesentlichen parallel über den ersten Leiterbahnen 303, überbrücken die zweiten Leiterbahnen 304 und sind zu den zweiten Leiterbahnen 304 elektrisch isoliert. Die metallischen Kontaktleitungen 306 haben die Aufgabe, die selbstjustierenden Kontakte 305 mit den metallischen Bitleitungen 307 elektrisch zu verbinden.

Die ersten Leiterbahnen 303 weisen eine Leiterbahnbreite 308 und die selbstjustierenden Kontakte 305 eine Kontaktbreite 309 auf. Da die Kontaktbreite 309 schmäler ist als die Leiterbahnbreite 308, können die Anforderungen an die Präzision der Kontaktposition bei der Herstellung der selbstjustierenden Kontakte 305 im Vergleich zum Stand der Technik reduziert werden. Dadurch wird der Aufwand während der Herstellung der erfindungsgemäßen Halbleiterstruktur 300 deutlich reduziert.

Zwischen jeweils zwei benachbarten zweiten Leiterbahnen 304 befindet sich stets ein selbstjustierender Kontakt 305 zwischen der jeweiligen ersten Leiterbahn 303 und der darüber liegenden metallischen Kontaktleitung 306. Gemäß diesem Ausführungsbeispiel bestehen die selbstjustierenden Kontakte 305 sowie die metallischen Kontaktleitungen 306 aus Wolfram und werden in einem gemeinsamen Metallisierungsprozess hergestellt. Dazu wird auf Stellen der entstehenden Halbleiterstruktur 300, an welchen keine selbstjustierenden Kontakte 305 sowie keine metallischen Kontaktleitungen 306 gewünscht werden, eine Schutzschicht aufgebracht. Die in der Schutzschicht verbleibenden Öffnungen werden anschließend zur Bildung der selbstjustierenden Kontakte 305 sowie der metallischen Kontaktleitungen 306 mit Metall aufgefüllt. Abschließend wird die Schutzschicht wieder entfernt.

In **Fig.4** ist ein Ausschnitt eines Querschnitts durch die Halbleiterstruktur 300 aus Fig.3 entlang der Schnittlinie B-B gezeigt.

Über der Substratoberfläche 302 und somit oberhalb der in dem Halbleitersubstrat 301 integrierten ersten Leiterbahnen 303 befindet sich eine erste Isolationsschicht 401. Die erste Isolationsschicht 401 ist zur elektrischen Isolierung zwischen den zweiten Leiterbahnen 304 und den ersten Leiterbahnen 303 vorgesehen. Des Weiteren sind die zweiten Leiterbahnen 304 von einer zweiten Isolationsschicht 402 eingekapselt, um eine elektrische Isolierung der zweiten Leiterbahnen 304 zu den selbstjustierenden Kontakten 305 und zu den metallischen Kontaktleitungen 306 zu gewährleisten.

Zum Einkapseln der zweiten Leiterbahnen 304 wird zunächst ein Isolationsmaterial flächig über den zweiten Leiterbahnen 304 abgeschieden. Über den zweiten Leiterbahnen 304 wird nachfolgend eine Ätzmaske aufgebracht, welche die zweiten Leiterbahnen 304 sowie einen leiterbahnnahen Bereich zwischen benachbarten zweiten Leiterbahnen 304 überdeckt. Nun wird das Isolationsmaterial an freiliegenden Stellen, welche nicht von der Ätzmaske bedeckt werden, bis zur Substratoberfläche 302 entfernt. Anschließend wird die Ätzmaske wieder entfernt. Für die zweite Isolationsschicht 402 wird in diesem Ausführungsbeispiel der Erfindung Siliziumnitrid (Si₃N₄) verwendet.

Die freiliegenden Öffnungen zwischen den zweiten Leiterbahnen 304 werden dann mit einem Isolationsmaterial angefüllt, welches selektiv zum Isolationsmaterial der zweiten Isolationsschicht 402 geätzt werden kann. In diesem Ausführungsbeispiel der Erfindung wird als Isolationsmaterial zwischen den zweiten Leiterbahnen 304 Siliziumdioxid (SiO₂) verwendet.

Zum Erzeugen der selbstjustierenden Kontakte 305 wird nun mittels einer Ätzmaske das Siliziumdioxid (SiO₂) in schmalen aber langen Bereichen, welche im Wesentlichen parallel zu den ersten Leiterbahnen 303 ausgerichtet sind, über den jeweiligen ersten Leiterbahnen 303 entfernt. Dabei weisen sowohl die Ätzmaske als auch die entstehenden Öffnungen die gewünschte Kontaktbreite 309 auf. Somit werden die ersten Leiterbahnen 303 lokal wieder freigelegt. Die freigelegten ersten Leiterbahnen 303 werden anschließend mit einem elektrisch leitenden Material, gemäß diesem Ausführungsbeispiel mit Wolfram, bedeckt, bis das elektrisch leitende Material mit der zweiten Isolationsschicht 402 eine gemeinsame Oberfläche 403 im Wesentlichen parallel zur Substratoberfläche 302 bildet.

Nun werden die Öffnungen der Ätzmaske über der gemeinsamen Oberfläche 403 ebenfalls mit dem elektrisch leitenden Material angefüllt, wodurch die metallischen Kontaktleitungen 306 gebildet werden. Anschließend kann die Ätzmaske wieder entfernt werden.

Abschließend befinden sich auf den metallischen Kontaktleitungen 306 noch die metallischen Bitleitungen 307, welche zum Einkoppeln von elektrischen Signalen in die Halbleiterstruktur 300 notwendig sind.

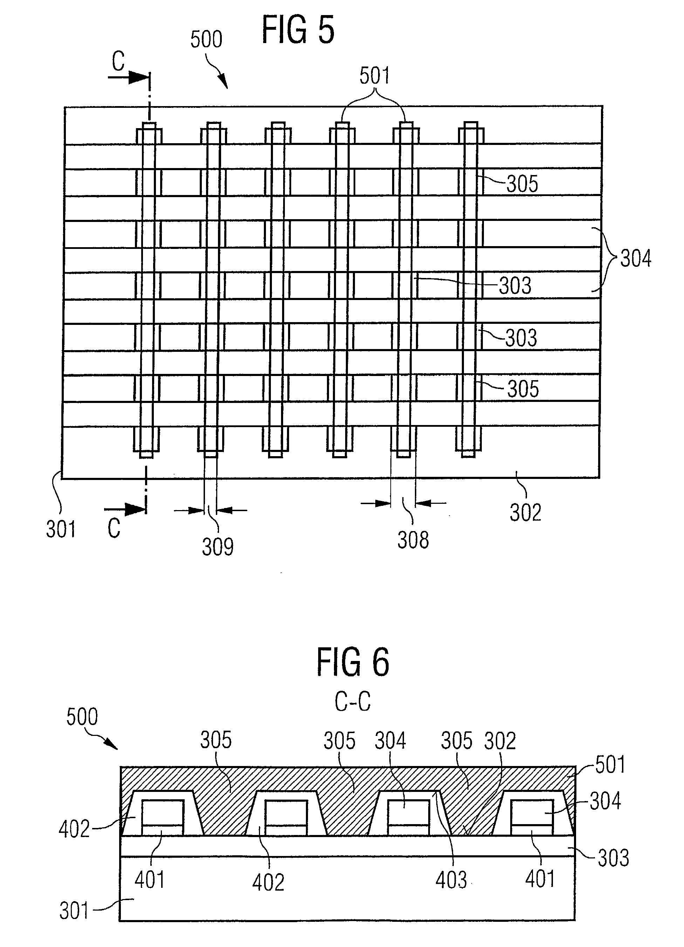

**Fig.5** zeigt eine Draufsicht auf eine Halbleiterstruktur 500 gemäß einem zweiten Ausführungsbeispiel der Erfindung.

Das zweite Ausführungsbeispiel der Erfindung unterscheidet sich von dem ersten Ausführungsbeispiel der Erfindung lediglich dadurch, dass die metallischen Kontaktleitungen 306 sowie die metallischen Bitleitungen 307 zu metallischen Kontakt- und Bitleitungen 501 kombiniert werden.

Dies kann beispielsweise folgendermaßen erreicht werden: Zunächst wird die zur Herstellung der selbstjustierenden Kontakte 305 notwendige Ätzmaske auf der entstehenden Halbleiterstruktur 500 mit einer größeren Dicke als gemäß dem ersten Ausführungsbeispiel der Erfindung erzeugt. Werden nun nach dem Erzeugen der selbstjustierenden Kontakte 305 die verbleibenden Öffnungen der Ätzmaske vollständig mit dem elektrisch leitfähigen Material angefüllt und die Ätzmaske anschließend entfernt, entstehen metallische Kontaktleitungen 306, welche gleichzeitig als metallische Bitleitungen 307 verwendet werden können. Daraus resultieren folglich kombinierte metallische Kontakt- und Bitleitungen 501.

Auf Grund der Einsparung der letzten Metallisierungsebene, in welcher die eigenständigen metallischen Bitleitungen 307 vorhanden gewesen wären, kann eine signifikante Reduzierung der Herstellungskosten für die Halbleiterstruktur 500 gemäß dem zweiten Ausführungsbeispiel der Erfindung erreicht werden. Damit können die gesamten Herstellungskosten um bis zu 10 % reduziert werden.

**Fig.6** zeigt einen Ausschnitt eines Querschnitts durch die Halbleiterstruktur 500 aus Fig.5 entlang der Schnittlinie C-C.

Diese Darstellung zeigt deutlich die Existenz von kombinierten metallischen Kontakt- und Bitleitungen 501. Für weitere Details sei auf die Beschreibung zu Fig.4 verwiesen.

**Bezugszeichenliste**
- 100: Halbleiterstruktur gemäß Stand der Technik
- 101: Halbleitersubstrat
- 102: Substratoberfläche
- 103: erste Leiterbahn
- 104: zweite Leiterbahn
- 105: selbstjustierender Kontakt
- 106: metallische Bitleitung
- 201: erste Isolationsschicht
- 202: zweite Isolationsschicht
- 203: dritte Isolationsschicht
- 204: gemeinsame Oberfläche
- 300: Halbleiterstruktur gemäß erstem Ausführungsbeispiel der Erfindung
- 301: Halbleitersubstrat
- 302: Substratoberfläche
- 303: erste Leiterbahn
- 304: zweite Leiterbahn
- 305: selbstjustierender Kontakt
- 306: metallische Kontaktleitung
- 307: metallische Bitleitung
- 308: Leiterbahnbreite
- 309: Kontaktbreite
- 401: erste Isolationsschicht
- 402: zweite Isolationsschicht
- 403: gemeinsame Oberfläche
- 500: Halbleiterstruktur gemäß zweitem Ausführungsbeispiel der Erfindung
- 501: metallische Kontakt- und Bitleitung

## Patentansprüche

1. Halbleiterstruktur
• mit mehreren im Wesentlichen parallel zueinander verlaufenden ersten Leiterbahnen, welche in einem Halbleitersubstrat vorgesehen sind,
• mit mehreren im Wesentlichen parallel zueinander verlaufenden zweiten Leiterbahnen, welche sich auf dem Halbleitersubstrat befinden, welche zu den ersten Leiterbahnen isoliert sind und welche zusammen mit den ersten Leiterbahnen ein Gitter bilden, und
• mit mehreren dritten Leiterbahnen, welche im Wesentlichen parallel über den ersten Leiterbahnen angeordnet sind, welche teilweise die zweiten Leiterbahnen überdecken und welche zu den zweiten Leiterbahnen isoliert sind,
• wobei zwischen jeweils zwei benachbarten zweiten Leiterbahnen ein elektrischer Kontakt zwischen jeder ersten Leiterbahn und der jeweiligen darüber liegenden dritten Leiterbahn vorgesehen ist.

2. Halbleiterstruktur gemäß Anspruch 1,
bei welcher die ersten Leiterbahnen jeweils eine erste Breite und die elektrischen Kontakte jeweils eine zweite Breite aufweisen, wobei die beiden Breiten parallel zu den ersten Leiterbahnen sowie senkrecht zur Längsrichtung der ersten Leiterbahnen ausgerichtet sind und wobei die zweite Breite kleiner als die erste Breite ist.

3. Halbleiterstruktur gemäß Anspruch 1 oder 2,
bei welcher jeweils von zwei benachbarten ersten Leiterbahnen und einer darüber liegenden zweiten Leiterbahn ein Transistor gebildet wird.

4. Halbleiterstruktur gemäß einem der Ansprüche 1 bis 3,
bei welcher unter der zweiten Leiterbahn zwischen benachbarten ersten Leiterbahnen eine Oxid-Nitrid-Oxid-Schichtenfolge auf dem Halbleitersubstrat vorgesehen ist.

5. Halbleiterstruktur gemäß einem der Ansprüche 1 bis 4,
bei welcher der Transistor ein 2-bit-Speichertransistor ist.

6. Halbleiterstruktur gemäß einem der Ansprüche 1 bis 5,
bei welcher die elektrischen Kontakte die zweiten Leiterbahnen isoliert überbrücken und derart ausgebildet sind, dass sich elektrische Kontakte, welche über einer einzelnen der ersten Leiterbahnen benachbart sind, überlappen und somit selbst die dritten Leiterbahnen bilden.

7. Verfahren zur elektrischen Kontaktierung von mehreren im Wesentlichen parallel zueinander verlaufenden ersten Leiterbahnen, welche in einem Halbleitersubstrat vorgesehen sind,
• bei dem mehrere im Wesentlichen parallel zueinander verlaufende zweite Leiterbahnen derart auf dem Halbleitersubstrat aufgebracht werden, dass die zweiten Leiterbahnen zusammen mit den ersten Leiterbahnen ein Gitter bilden und dass die zweiten Leiterbahnen zu den ersten Leiterbahnen isoliert werden,
• bei dem mehrere dritte Leiterbahnen im Wesentlichen parallel über den ersten Leiterbahnen und teilweise über den zweiten Leiterbahnen aufgebracht werden, wobei zwischen den dritten Leiterbahnen und den zweiten Leiterbahnen eine elektrische Isolierung erzeugt wird, und
• bei dem zwischen jeweils zwei benachbarten zweiten Leiterbahnen ein elektrischer Kontakt zur elektrischen Kontaktierung der ersten Leiterbahnen zwischen jeder ersten Leiterbahn und der jeweiligen darüber liegenden dritten Leiterbahn erzeugt wird.

8. Verfahren gemäß Anspruch 7,
bei dem die ersten Leiterbahnen jeweils mit einer ersten Breite und die elektrischen Kontakte jeweils mit einer zweiten Breite erzeugt werden, wobei die beiden Breiten parallel zu den ersten Leiterbahnen sowie senkrecht zur Längsrichtung der ersten Leiterbahnen ausgerichtet sind und wobei die zweite Breite kleiner als die erste Breite ist.

9. Verfahren gemäß Anspruch 7 oder 8,
bei dem die zweiten Leiterbahnen derart über den ersten Leiterbahnen erzeugt werden, dass jeweils zwei benachbarte erste Leiterbahnen und eine darüber liegende zweite Leiterbahn einen Transistor bilden.

10. Verfahren gemäß einem der Ansprüche 7 bis 9,
bei dem vor dem Erzeugen der zweiten Leiterbahnen zwischen benachbarten ersten Leiterbahnen eine Oxid-Nitrid-Oxid-Schichtenfolge auf dem Halbleitersubstrat erzeugt wird.

11. Verfahren gemäß Anspruch 9 oder 10,
bei dem der Transistor derart erzeugt wird, dass er als 2-bit-Speichertransistor verwendet werden kann.

12. Verfahren gemäß einem der Ansprüche 7 bis 11,
bei dem die elektrischen Kontakte derart ausgebildet werden, dass sie die zweiten Leiterbahnen überbrücken und dass sich elektrische Kontakte, welche über einer einzelnen der ersten Leiterbahnen benachbart sind, überlappen und somit selbst die dritten Leiterbahnen bilden.
